# EUROPEAN PATENT APPLICATION

(11) **EP 4 838 530 A1**
(43) Date of publication of application: **11.11.2026**
(21) Application number: 26152502.6
(22) Date of filing: 19.01.2026
(51) Int. Cl.: G11C 16/08, G11C 16/26, G11C 16/30, G11C 16/32

(54) **MEMORY DEVICE AND OPERATING METHOD OF MEMORY DEVICE**

(30) Priority: 09.05.2025 KR 20250060500
(71) Applicant: SK hynix Inc., Bubal-eub Icheon-si Gyeonggi-do 17336 (KR)
(72) Inventor: KWON, Jae Kwan, 17336 Icheon-si, Gyeonggi-do (KR)
(74) Representative: Isarpatent

(57) **Abstract**

The present disclosure relates to a memory device and operating method of memory device. A memory device includes a first memory block, a second memory block, a decoder and a control circuit. The first memory block is coupled to first word lines. The second memory block is coupled to second word lines. The decoder connects global word lines to the first word lines, respectively, in response to a first memory block selection signal and connects the global word lines to the second word lines, respectively, in response to a second memory block selection signal. The control circuit activates the first memory block selection signal to perform a first read operation on a selected first word line during a first interval, activates the first memory block selection signal and the second memory block selection signal during a second interval, and activates the second memory block selection signal to perform a second read operation on a selected second word line during a third interval.

## Description

### BACKGROUND

### 1. TECHNICAL FIELD

The present application relates to a memory device.

### 2. RELATED ART

A memory device is a component of electronic devices and has a wide range of modern applications. For example, a memory device can be utilized in technologies such as computing, communications, artificial intelligence, and memory. The memory device includes components such as transistors, diodes, and integrated circuits (ICs).

The memory device performs a read operation to read data stored in selected memory cells. During this process, a read voltage is applied to a selected word line, and a relatively high pass voltage is applied to unselected word lines.

### SUMMARY

In an embodiment, a memory device may include a first memory block, a second memory block, a decoder, and a control circuit. The first memory block may be coupled to a plurality of first word lines. The second memory block may be coupled to a plurality of second word lines. The decoder may be configured to couple a plurality of global word lines to the plurality of first word lines, respectively, in response to a first memory block selection signal and may be configured to couple the plurality of global word lines to the plurality of second word lines, respectively, in response to a second memory block selection signal. The control circuit may be configured to activate the first memory block selection signal to perform a first read operation on a selected first word line among the plurality of first word lines during a first interval, may be configured to activate the first memory block selection signal and the second memory block selection signal during a second interval subsequent to the first interval, and may be configured to activate the second memory block selection signal to perform a second read operation on a selected second word line among the plurality of second word lines during a third interval subsequent to the second interval.

In an embodiment, a method of operating a memory device may include applying a pass voltage to unselected first word lines among a plurality of first word lines coupled to a first memory block to perform a first read operation on a selected first word line among the plurality of first word lines; transferring charge retained at the unselected first word lines to target word lines among a plurality of second word lines coupled to a second memory block before performing a second read operation on a selected second word line among the plurality of second word lines; and applying the pass voltage to unselected second word lines among the plurality of second word lines to perform the second read operation.

In an embodiment, a method of operating a memory device may include raising voltage levels of target word lines to a first voltage level using charge retained in source word lines; and raising voltage levels of unselected word lines of a read operation among the target word lines from the first voltage level to a second voltage level using a voltage output from a voltage generation circuit.

In an embodiment, a method may include performing a first read operation on a selected first word line coupled to a first memory block while applying a pass voltage to unselected word lines coupled to the first memory block and transferring charge retained at the unselected word lines to target word lines coupled to a second memory block before performing a second read operation on a selected second word line coupled to the second memory block.

### BRIEF DESCRIPTION OF THE DRAWINGS

FIG. 1 is a block diagram illustrating a memory device according to an embodiment of the present disclosure.
FIG. 2 is a circuit diagram illustrating a memory block according to an embodiment of the present disclosure.
FIG. 3 is a circuit diagram illustrating a connection structure of memory blocks and a decoder according to an embodiment of the present disclosure.
FIG. 4 is a timing diagram of a first read operation and a second read operation according to an embodiment of the present disclosure.
FIG. 5 is a timing diagram of a first read operation and a second read operation including a charge recycling operation according to an embodiment of the present disclosure.
FIG. 6 is a timing diagram of a first read operation and a second read operation including a charge recycling operation according to an embodiment of the present disclosure.
FIG. 7 is a diagram illustrating a charge recycling operation according to an embodiment of the present disclosure.
FIG. 8 is a flowchart illustrating a method of operating a memory device according to an embodiment of the present disclosure.

### DETAILED DESCRIPTION

Because of advancements in manufacturing technologies, increased power consumption results from an increase in the quantity of word lines to which the pass voltage is applied. Various embodiments of the present disclosure can improve the speed of a read operation and reduce power consumption.

Embodiments of the present disclosure are described in detail with reference to the accompanying drawings. Specific structural or functional descriptions of embodiments are provided as examples to describe concepts that are disclosed in the present application. Examples or embodiments in accordance with the concepts may be carried out in various forms, and the scope of the present disclosure is not limited to the examples or embodiments described in this specification.

When one element is identified as "connected" or "coupled" to another element, the elements may be connected or coupled directly or through at least one intervening element between the elements. When two elements are identified as "directly connected" or "directly coupled," one element is directly connected or directly coupled to the other element without an intervening element between the two elements.

The word "predetermined" as used with respect to a parameter, such as a predetermined time period or a predetermined command, includes a value for the parameter that is determined prior to use of the parameter in a process or algorithm. The value of the parameter may be determined before the process or algorithm begins. The value for the parameter may be determined during the process or algorithm but before the parameter is used during the process or algorithm.

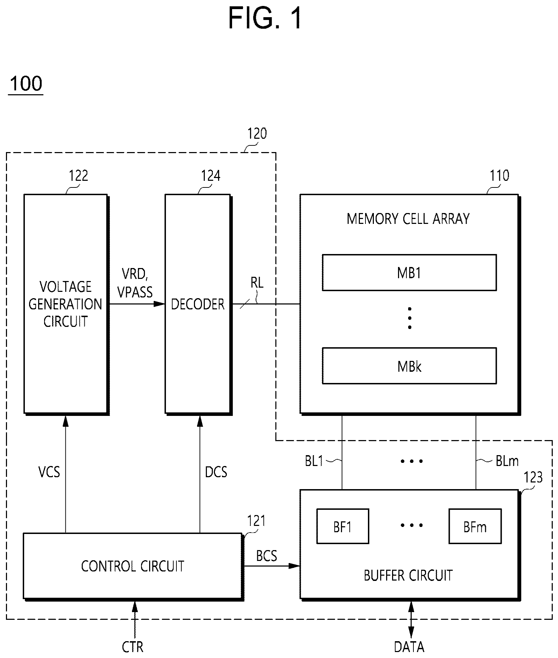

FIG. 1 is a block diagram illustrating a memory device 100 according to an embodiment of the present disclosure.

Referring to FIG. 1, the memory device 100 operates in response to an external signal CTR received from an external controller. For example, the memory device 100 stores data DATA received from the controller by performing a program operation in response to the external signal CTR. The memory device 100 outputs the stored data DATA to the controller by performing a read operation in response to the external signal CTR.

The memory device 100 includes a memory cell array 110 and a peripheral circuit 120.

The memory cell array 110 includes a plurality of memory blocks MB1 to MBk, where k is an integer larger than 1. The memory blocks MB1 to MBk include memory cells in which data DATA is stored. Each of the memory blocks MB1 to MBk are connected to row lines RL and bit lines BL1 to BLm, where m is an integer larger than 1. Each of the memory blocks MB1 to MBk is selected through control of the row lines RL and the bit lines BL1 to BLm and stores data DATA. Each memory block may be a unit on which an erase operation is performed.

The peripheral circuit 120 stores data DATA in the memory cell array 110 and reads data DATA from the memory cell array 110 in response to the external signal CTR. The peripheral circuit 120 includes a control circuit 121, a voltage generation circuit 122, a buffer circuit 123, and a decoder 124.

The control circuit 121 controls operations of the voltage generation circuit 122, the buffer circuit 123, and the decoder 124 to perform internal operations of the memory device 100 in response to the external signal CTR. For example, the control circuit 121 generates and outputs a voltage control signal VCS to the voltage generation circuit 122 to control the voltage generation circuit 122. The control circuit 121 generates and outputs a buffer control signal BCS to the buffer circuit 123 to control the buffer circuit 123. The control circuit 121 generates and outputs a decoder control signal DCS to the decoder 124 to control the decoder 124.

The voltage generation circuit 122 generates various voltages in response to the voltage control signal VCS and outputs the voltages to the buffer circuit 123, the decoder 124, and other circuits of the memory device 100. For example, the voltage generation circuit 122 outputs a read voltage VRD and a pass voltage VPASS to the decoder 124.

The buffer circuit 123 is coupled to the memory cell array 110 using bit lines BL1 to BLm. The buffer circuit 123 includes buffers BF1 to BFm coupled to the bit lines BL1 to BLm, respectively. The buffers BF1 to BFm are coupled with memory cells included in the memory cell array 110 using the bit lines BL1 to BLm. The buffers BF1 to BFm receive and store, from the controller, data DATA to be stored in the memory cells. The buffers BF1 to BFm store the data DATA read from the memory cells for output to the controller. The buffers BF1 to BFm operate in response to the buffer control signal BCS.

The decoder 124 is coupled to the memory blocks MB1 to MBk through the row lines RL. The row lines RL include one or more drain selection lines, a plurality of word lines, and one or more source selection lines, each coupled to a corresponding one of memory blocks MB1 to MBk. The decoder 124 applies the read voltage VRD and the pass voltage VPASS, generated and output by the voltage generation circuit 122, to a selected one of the memory blocks MB1 to MBk in response to the decoder control signal DCS.

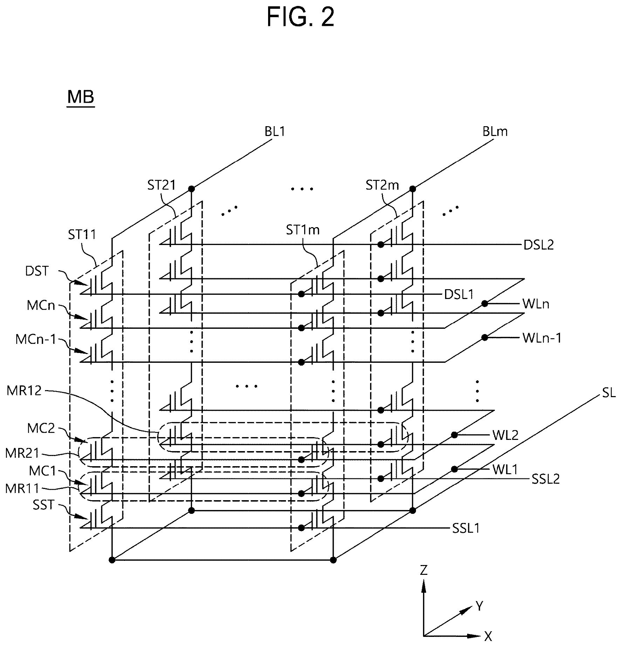

FIG. 2 is a circuit diagram illustrating a memory block MB according to an embodiment of the present disclosure. Each of the memory blocks MB1 to MBk of FIG. 1 may be configured similarly to the memory block MB.

Referring to FIG. 2, the memory block MB is coupled to the peripheral circuit 120 through drain selection lines DSL1 and DSL2, source selection lines SSL1 and SSL2, word lines WL1 to WLn, bit lines BL1 to BLm, and a source line SL.

The memory block MB includes strings ST11 to ST1m, ST21 to ST2m. Each of the strings ST11 to ST1m, ST21 to ST2m extend along a vertical direction (Z direction). Within the memory block MB, m strings are arranged in a row direction (X direction). In FIG. 2, two strings are shown arranged in a column direction (Y direction) for simplicity of illustration, and three or more strings may be arranged in the column direction (Y direction).

The strings ST11 to ST1m, ST21 to ST2m may be configured identically. For example, the string ST11 includes a source selection transistor SST, memory cells MC1 to MCn, and a drain selection transistor DST, coupled in series between the source line SL and the bit line BL1, where m is an integer larger than 1. A source of the source selection transistor SST is coupled to the source line SL, and a drain of the drain selection transistor DST is coupled to the bit line BL1. The memory cells MC1 to MCn are coupled in series between the source selection transistor SST and the drain selection transistor DST. In an embodiment, a plurality of source selection transistors are coupled in series between the source line SL and the memory cell MC1. In an embodiment, a plurality of drain selection transistors are coupled in series between the bit line BL1 and the memory cell MCn.

Source selection transistors at the same position in a vertical direction are configured as shown in FIG. 2. For example, the gates of the source selection transistors of strings arranged in the same row are coupled to the same source selection line. For example, the gates of the source selection transistors of strings ST11 to ST1m in a first row are coupled to a source selection line SSL1. For example, the gates of the source selection transistors of a second row of strings ST21 to ST2m are coupled to a source selection line SSL2.

In an embodiment, source selection transistors of two or more rows of strings are coupled in common to a single source selection line. For example, the source selection transistors SST of the first row of strings ST11 to ST1m and the second row of strings ST21 to ST2m are coupled in common to one source selection line SSL1, SSL2, respectively, and the source selection transistors of the third and fourth rows of strings are coupled in common to one source selection line, respectively.

Drain selection transistors at the same position in a vertical direction may be configured as shown in FIG. 2. For example, the gates of the drain selection transistors of strings arranged in the same row are coupled to the same drain selection line. For example, the gates of the drain selection transistors of the strings ST11 to ST1m of the first row are coupled to the first drain selection line DSL1. For example, the gates of the drain selection transistors of the second row of the strings ST21 to ST2m are coupled to the second drain selection line DSL2.

Strings arranged in the same column are coupled to the same bit line. For example, strings ST11, ST21 in a first column are coupled to the bit line BL1. For example, strings ST1m, ST2m in an mth column are coupled to the bit line BLm.

Gates of memory cells at the same position in a vertical direction are coupled to the same word line. For example, in strings ST11 to ST1m and ST21 to ST2m, memory cells that are at the same position in a direction perpendicular to the memory cell MC1 are coupled to the word line WL1.

Among the memory cells, memory cells coupled to the same word line in the same row form one memory region. For example, memory cells coupled to the word line WL1 in the first row form memory region MR11. For example, memory cells coupled to the word line WL1 in the second row form memory region MR12. For example, memory cells coupled to word line WL2 in the first row form memory region MR21. Depending on the quantity of rows, each word line is coupled to multiple memory regions. The memory cells in one memory region may be accessed simultaneously.

In an embodiment, the memory block MB may be coupled to at least one dummy word line other than the word lines WL1 to WLn. In this example, the memory block MB includes dummy memory cells coupled to dummy word lines.

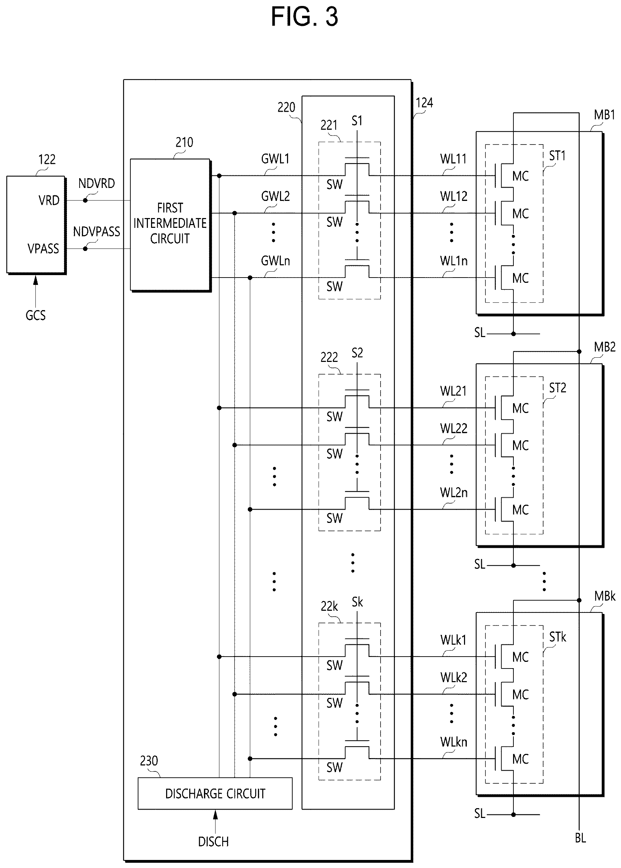

FIG. 3 is a circuit diagram illustrating a connection structure of the memory blocks MB1 to MBk and the decoder 124 according to an embodiment of the present disclosure.

Referring to FIG. 3, a bit line BLis one of the bit lines BL1 to BLm. A global control signal GCS, memory block selection signals S1 to Sk, and a discharge signal DISCH are included in the decoder control signal DCS.

The memory blocks MB1 to MBk respectively include strings ST1 to STk coupled between the bit line BL and a source line SL. Each of the strings ST1 to STk includes memory cells MC. Circuits, such as dummy memory cells and selection transistors, are not shown for simplicity of illustration.

The decoder 124 includes a first intermediate circuit 210, a second intermediate circuit 220, and a discharge circuit 230.

The first intermediate circuit 210 is coupled between the voltage generation circuit 122 and the second intermediate circuit 220. The first intermediate circuit 210 transmits the read voltage VRD and the pass voltage VPASS, generated by the voltage generation circuit 122, to global word lines GWL1 to GWLn in response to the global control signal GCS. The first intermediate circuit 210 includes a plurality of switches configured to selectively couple a read voltage node NDVRD, on which the read voltage VRD is output by the voltage generation circuit 122, and a pass voltage node NDVPASS, on which the pass voltage VPASS is output by the voltage generation circuit 122, to the global word lines GWL1 to GWLn in response to the global control signal GCS.

The second intermediate circuit 220 includes memory block selection circuits 221 to 22k corresponding to the memory blocks MB1 to MBk.

Each of the memory block selection circuits 221 to 22k couples the global word lines GWL1 to GWLn to word lines coupled to a corresponding one of the memory blocks MB1 to MBk in response to a corresponding one of the memory block selection signals S1 to Sk.

For example, the memory block selection circuit 221 includes a plurality of switches SW configured to couple the global word lines GWL1 to GWLn to word lines WL11 to WL1n coupled to the memory block MB1, respectively, in response to the memory block selection signal S1. The memory block selection circuit 221 transmits voltages applied to the global word lines GWL1 to GWLn to the word lines WL11 to WL1n when the memory block selection signal S1 is activated. The memory block selection circuits 222 to 22k may be configured similarly to the memory block selection circuit 221.

The discharge circuit 230 is coupled to the global word lines GWL1 to GWLn and is configured to selectively discharge the global word lines GWL1 to GWLn in response to the discharge signal DISCH.

A selected memory block includes a memory block among the memory blocks MB1 to MBk that includes a selected memory cell on which a read operation is performed. A selected word line includes a word line among the word lines coupled to the selected memory block, which is coupled to the selected memory cell. Unselected word lines include the word lines, other than or excluding the selected word line, among the word lines coupled to the selected memory block. A selected global word line includes a global word line, among the global word lines GWL1 to GWLn, that is coupled to the selected word line. Unselected global word lines GWL1 to GWLn include the global word lines among the global word lines GWL1 to GWLn other than or excluding the selected global word line.

During a read operation, the first intermediate circuit 210 transmits the read voltage VRD to the selected global word line and the pass voltage VPASS to the unselected global word lines in response to the global control signal GCS. The second intermediate circuit 220 transmits the read voltage VRD and the pass voltage VPASS, which are applied to the global word lines GWL1 to GWLn, to the word lines coupled to the selected memory block by coupling the global word lines GWL1 to GWLn to the word lines of the selected memory block in response to a memory block selection signal corresponding to the selected memory block. As a result, the read voltage VRD is applied to the selected word line, and the pass voltage VPASS is applied to the unselected word lines, such that a read operation is performed on the selected memory cell.

For example, the selected memory cell turns on or off in response to the read voltage VRD depending on the stored data, and the unselected memory cells included in the same string as the selected memory cell all turn on in response to the pass voltage VPASS. Therefore, a state of a corresponding bit line changes depending on whether the selected memory cell is turned on or off, and data stored in the selected memory cell is determined by sensing the state of the bit line, for example, by determining an amount of current or a voltage level of the bit line.

According to the present disclosure, the control circuit 121 activates a first memory block selection signal during a first interval to perform a first read operation on a selected first word line among first word lines, activates the first memory block selection signal and a second memory block selection signal during a second interval following the first interval, and activates a second memory block selection signal during a third interval following the second interval to perform a second read operation on a selected second word line among second word lines. During the second interval, a charge recycling operation is performed. Using the charge recycling operation, power consumption may be significantly reduced and the speed of the read operation may be improved, thereby enhancing operation performance of the memory device 100. Charge recycling includes conserving, transferring, switching, or maintaining charge from one line to another line, for example, to avoid preventable charging and discharging of voltage.

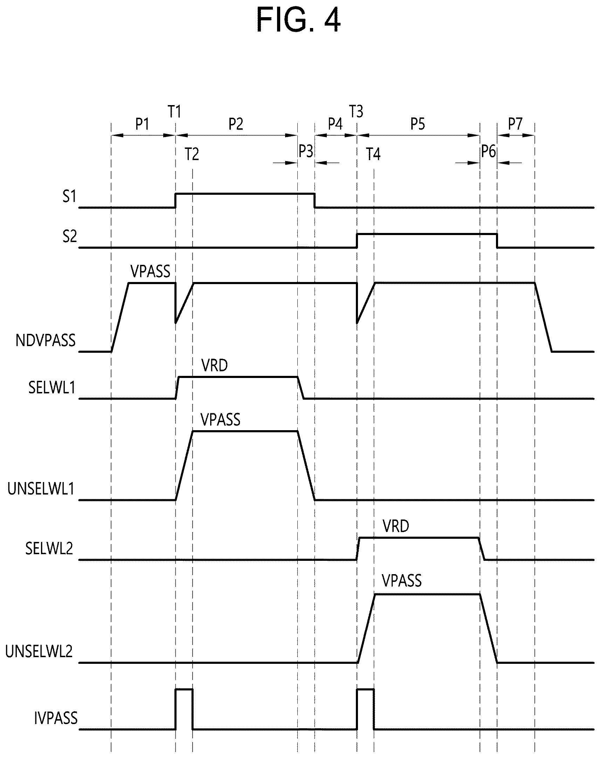

FIG. 4 is a timing diagram of a first read operation and a second read operation according to an embodiment of the present disclosure. The first read operation is performed on a first memory block, MB1, and the second read operation is performed on a second memory block memory block MB2.

Referring to FIG. 4, during interval P2, a first read operation is performed on a selected first word line SELWL1 among first word lines WL11 to WL1n of the first memory block MB1. During interval P5, a second read operation is performed on a selected second word line SELWL2 among second word lines WL21 to WL2n of the second memory block MB2. In an embodiment of FIG. 4, the selected first word line SELWL1 and the selected second word line SELWL2 are coupled to the same global word line or are coupled to different global word lines.

During intervals P1 to P7, the voltage generation circuit 122 generates the pass voltage VPASS and outputs the pass voltage VPASS on the pass voltage node NDVPASS. Although not shown, during intervals P1 to P7, the voltage generation circuit 122 generates the read voltage VRD and outputs the read voltage VRD on the read voltage node NDVRD.

During interval P2, to perform the first read operation on the first memory block MB1, a first memory block selection signal S1 is activated. The decoder 124 applies the read voltage VRD to the selected first word line SELWL1 of the first memory block MB1 and applies the pass voltage VPASS to unselected first word lines UNSELWL1 of the first memory block MB1.

At time T1 when interval P2 starts, because the quantity of unselected first word lines UNSELWL1 is very large, a current IVPASS at the pass voltage node NDVPASS temporarily increases significantly, and a voltage level at the pass voltage node NDVPASS temporarily drops sharply.

At a subsequent time T2, a voltage level at the pass voltage node NDVPASS is restored to the pass voltage VPASS. Voltage levels of the unselected first word lines UNSELWL1 reach the pass voltage VPASS, after which data is read from the selected first memory cells of the first memory block MB1 and stored in the buffer circuit 123.

During interval P3, while the first block selection signal S1 remains activated, the selected first word line SELWL1 and the unselected first word lines UNSELWL1 are discharged through the discharge circuit 230.

During interval P4, the first memory block selection signal S1 is deactivated. The data read from the selected first memory cells of the first memory block MB1 is output to the controller.

During interval P5, to perform the second read operation on the second memory block MB2, a second memory block selection signal S2 is activated. The decoder 124 applies the read voltage VRD to a selected second word line SELWL2 of the second memory block MB2 and applies the pass voltage VPASS to unselected second word lines UNSELWL2 of the second memory block MB2. A change in voltage level and current IVPASS at the pass voltage node NDVPASS between time T3 and time T4 is similar to the change in voltage level and current IVPASS at the pass voltage node NDVPASS between time T1 and time T2. During interval P5, data is read from selected second memory cells of the second memory block MB2 and stored in the buffer circuit 123.

During interval P6, while the second memory block selection signal S2 remains activated, the selected second word line SELWL2 and the unselected second word lines UNSELWL2 may be discharged through the discharge circuit 230.

During interval P7, the second memory block selection signal S2 may be deactivated. Data read from the selected second memory cells of the second memory block MB2 is output to the controller. When a subsequent read operation is not performed after interval P7 within a predetermined time period, the voltage generation circuit 122 stops generating the pass voltage VPASS, and the pass voltage node NDVPASS is discharged.

When the quantity of word lines in each memory block is, for example, 232, then the quantity of unselected word lines in each read operation is 231. The process of raising the unselected first word lines UNSELWL1 and the unselected second word lines UNSELWL2 to the pass voltage VPASS at time T1 and time T3 may result in very high power consumption. As shown in the example of FIG. 4, when two or more read operations are performed consecutively, simply discharging the charge accumulated on the unselected word lines by the pass voltage VPASS during interval P3 may be undesirable and inefficient from the perspective of energy utilization.

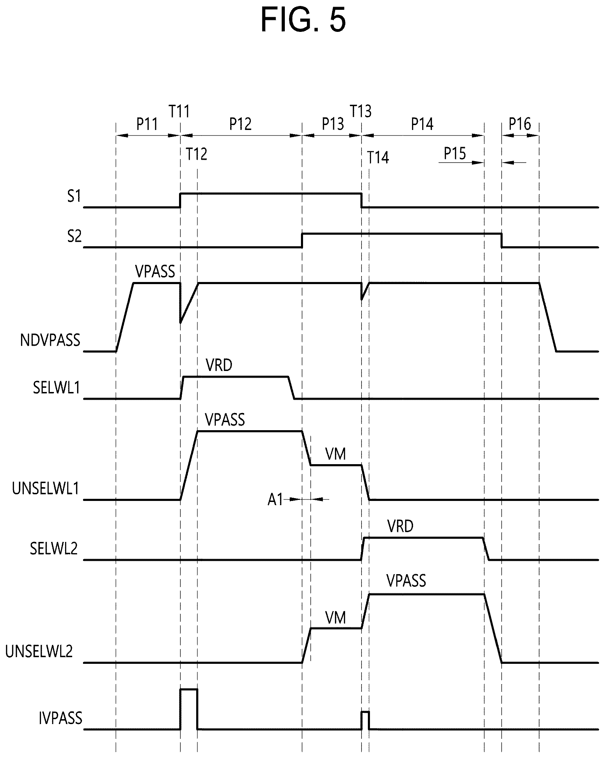

FIG. 5 is a timing diagram of a first read operation and a second read operation including a charge recycling operation according to an embodiment of the present disclosure.

Referring to FIG. 5, during interval P12, a first read operation is performed on the selected first word line SELWL1 of the first memory block MB1. During interval P14, a second read operation is performed on the selected second word line SELWL2 of the second memory block MB2. In an embodiment of FIG. 5, the selected first word line SELWL1 and the selected second word line SELWL2 are coupled to the same global word line, and the unselected first word lines UNSELWL1 and the unselected second word lines UNSELWL2 are coupled to corresponding global word lines.

A charge recycling operation is performed during interval P13 between the first read operation and the second read operation. The charge recycling operation includes moving or transferring charges, stored or charged on the unselected first word lines UNSELWL1 of the first memory block MB1 during the first read operation by applying the pass voltage VPASS, to target word lines TG of the second word lines WL21 to WL2n of the second memory block MB2, instead of discharging the lines, such as during interval P3 of FIG. 4. The target word lines TG during the charge recycling operation are word lines to which recycled charges are transferred and are second word lines coupled through common global word lines to unselected first word lines from the first read operation. The unselected first word lines UNSELWL1 from the first memory block MB1, such as the first word lines transferring the recycled charges to the target word lines TG, are referred to as source word lines during the charge recycling operation.

In the example of FIG. 5, the target word lines TG are the unselected second word lines UNSELWL2. To perform the charge recycling operation during interval P13, the first memory block selection signal S1 and the second memory block selection signal S2 are activated during the same time period P13.

For example, during intervals P11 to P16, the voltage generation circuit 122 generates the pass voltage VPASS and outputs the pass voltage VPASS on the pass voltage node NDVPASS. During intervals P11 to P16, the voltage generation circuit 122 generates the read voltage VRD and outputs the read voltage VRD on the read voltage node NDVRD.

During interval P12, to perform the first read operation on the first memory block MB1, the control circuit 121 activates the first memory block selection signal S1. The decoder 124 applies the read voltage VRD to the selected first word line SELWL1 of the first memory block MB1 and applies the pass voltage VPASS to the unselected first word lines UNSELWL1 of the first memory block MB1. For example, the decoder 124 couples a global word line, among the global word lines GWL1 to GWLn, coupled to the selected first word line SELWL1 to the read voltage node NDVRD and couples global word lines coupled to corresponding unselected first word lines UNSELWL1 to the pass voltage node NDVPASS.

Accordingly, during interval P12, data is read from selected first memory cells of the first memory block MB1 and stored in the buffer circuit 123. A change in a voltage level and current IVPASS at the pass voltage node NDVPASS between time T11 and time T12 may be similar to the change in a voltage level and current IVPASS at the pass voltage node NDVPASS between time T1 and time T2 in FIG. 4.

At a predetermined time period before entering interval P13, the control circuit 121 discharges the selected first word line SELWL1 using the discharge circuit 230.

During interval P13, the control circuit 121 performs the charge recycling operation by activating the second memory block selection signal S2 while maintaining the activation of the first memory block selection signal S1. For example, while the first memory block selection signal S1 and the second memory block selection signal S2 are activated, the first word lines WL11 to WL1n of the first memory block MB1 are coupled to the second word lines WL21 to WL2n of the second memory block MB2, respectively, through the global word lines GWL1 to GWLn. Therefore, charges retained in the unselected first word lines UNSELWL1 of the first memory block MB1 are transferred or move to the target word lines TG of the second memory block MB2, such as the unselected second word lines UNSELWL2, and the voltage levels of the unselected first word lines UNSELWL1 and the unselected second word lines UNSELWL2 equalize at an intermediate level VM. A1 represents the time period during which movement of the recycled charges occurs.

During interval P13, because the selected first word line SELWL1 of the first memory block MB1 is at ground voltage level, the selected second word line SELWL2 of the second memory block MB2 remains at ground voltage level.

Because the distance between the memory blocks MB1 and MB2 and the pass voltage node NDVPASS may be long, when the pass voltage node NDVPASS is coupled to the unselected first word lines UNSELWL1 and the unselected second word lines UNSELWL2 during interval P13, the pass voltage node NDVPASS have little influence on the unselected first word lines UNSELWL1 and the unselected second word lines UNSELWL2 due to signal propagation delay.

During interval P13, the control circuit 121 outputs data read from the selected first memory cells of the first memory block MB1 to the controller.

During interval P14, the control circuit 121 deactivates the first memory block selection signal S1 and maintains activation of the second memory block selection signal S2 to perform the second read operation on the second memory block MB2. The decoder 124 applies the read voltage VRD to the selected second word line SELWL2 of the second memory block MB2 and applies the pass voltage VPASS to the unselected second word lines UNSELWL2 of the second memory block MB2. For example, the decoder 124 couples a global word line, among the global word lines GWL1 to GWLn, coupled to the selected second word line SELWL2 to the read voltage node NDVRD and couples global word lines coupled to the unselected second word lines UNSELWL2 to the pass voltage node NDVPASS. Accordingly, data is read from selected second memory cells of the second memory block MB2 and stored in the buffer circuit 123.

At time T13 when interval P14 begins, during the process of raising voltage levels of the unselected second word lines UNSELWL2 from the intermediate level VM to the pass voltage VPASS, the current IVPASS at the pass voltage node NDVPASS temporarily increases, and a voltage level at the pass voltage node NDVPASS temporarily drops. Because the unselected second word lines UNSELWL2 are already at the intermediate level VM due to the charge recycling operation during interval P13, the current IVPASS at time T13 is smaller than the current IVPASS at time T3 in FIG. 4, thereby reducing power consumption in this example.

The time for the voltage levels of the unselected second word lines UNSELWL2 to reach the pass voltage VPASS may also be reduced. The time period from time T13 to time T14 may be shorter than the time period from time T3 to time T4 in FIG. 4. Therefore, the execution time of the read operation may be reduced, and the operational performance of the memory device 100 may be improved.

During interval P15, when a subsequent read operation is not performed within a predetermined time period after the second read operation, the control circuit 121 discharges the selected second word line SELWL2 and the unselected second word lines UNSELWL2 using the discharge circuit 230 while maintaining activation of the second memory block selection signal S2.

During interval P16, the control circuit 121 deactivates the second memory block selection signal S2. The control circuit 121 outputs data read from the selected second memory cells of the second memory block MB2 to the controller. After interval P16, the control circuit 121 controls the voltage generation circuit 122 to stop generating the pass voltage VPASS.

Optionally, when a third read operation on a third memory block is performed following the second read operation, a charge recycling operation is performed after interval P14 similarly to the charge recycling operation performed during interval P13. By activating the second memory block selection signal S2 and a third memory block selection signal of the third memory block during the same time period, charges retained in the unselected second word lines UNSELWL2 of the second memory block MB2 are transferred or moved to target word lines of the third memory block.

In an embodiment, the control circuit 121 continuously performs the first read operation and the second read operation while performing the charge recycling operation in response to a single predetermined command. The predetermined command may be, for example, a sequential read command.

In an embodiment, the global control signal GCS remains activated during intervals P12 to P14. Accordingly, during intervals P12 to P14, the decoder 124 continuously couples the pass voltage node NDVPASS and the read voltage node NDVRD to the global word lines GWL1 to GWLn.

In an embodiment, the global control signal GCS is activated during intervals P12 and P14 and deactivated during interval P13. Accordingly, during interval P13, the decoder 124 does not couple the pass voltage node NDVPASS and the read voltage node NDVRD to the global word lines GWL1 to GWLn.

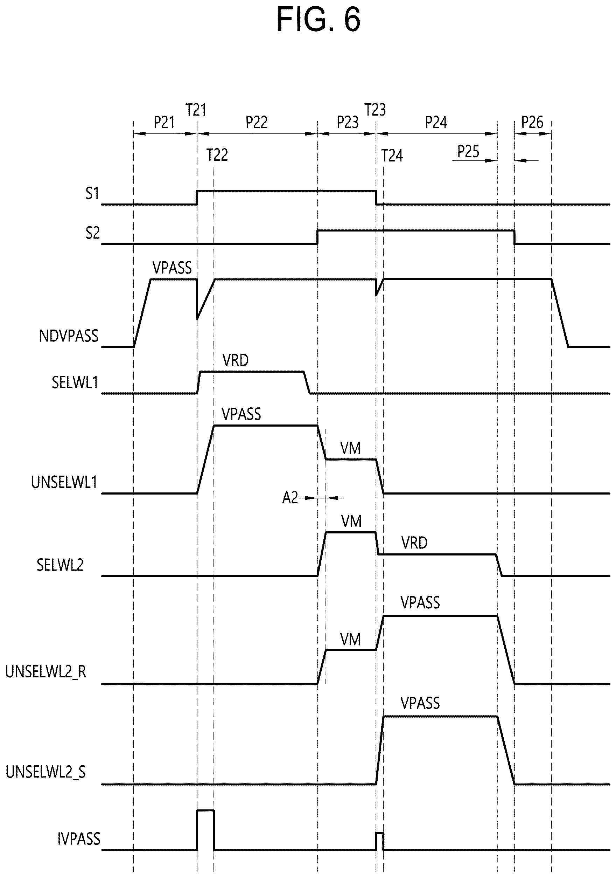

FIG. 6 is a timing diagram of a first read operation and a second read operation including a charge recycling operation according to an embodiment of the present disclosure.

In the example of FIG. 6, the selected first word line SELWL1 of the first memory block MB1 and the selected second word line SELWL2 of the second memory block MB2 are coupled to different global word lines. Therefore, among the unselected second word lines UNSELWL2 in the second read operation, a second word line UNSELWL2_S coupled to the same global word line as the selected first word line SELWL1 in the first read operation is not a target word line TG in a charge recycling operation. The selected second word line SELWL2 in the second read operation is a target word line TG during the charge recycling operation. The unselected second word lines UNSELWL2_R, excluding the second word line UNSELWL2_S, are target word lines TG during the charge recycling operation.

For example, referring to FIG. 6, during interval P23, the control circuit 121 performs the charge recycling operation by activating the second memory block selection signal S2 while continuing to activate the first memory block selection signal S1. For example, while the first memory block selection signal S1 and the second memory block selection signal S2 are activated, the first word lines WL11 to WL1n of the first memory block MB1 are coupled to the second word lines WL21 to WL2n of the second memory block MB2, respectively, through the global word lines GWL1 to GWLn. Therefore, charges retained on the unselected first word lines UNSELWL1 of the first memory block MB1 move to the target word lines TG of the second memory block MB2, and the voltage levels of the unselected first word lines UNSELWL1 of the first memory block MB1 and the target word lines TG of the second memory block MB2 equalize at the intermediate level VM. A2 represents the time period during which movement of the recycled charges occurs.

During interval P23, because the selected first word line SELWL1 of the first memory block MB1 is at ground voltage level, the second word line, among the second word lines WL21 to WL2n coupled to the same global word line as the selected first word line SELWL1, remains at ground voltage level.

During interval P24, the decoder 124 applies the read voltage VRD to the selected second word line SELWL2 of the second memory block MB2 and applies the pass voltage VPASS to the unselected second word lines UNSELWL2 of the second memory block MB2. Therefore, a voltage level at the unselected second word line UNSELWL2_S rises from ground voltage to the pass voltage VPASS, and the voltage levels of the unselected second word lines UNSELWL2_R, except for the unselected second word line UNSELWL2_S, rises from the intermediate level VM to the pass voltage VPASS.

The operations performed during intervals P21, P22, P25, and P26 may be similar to the operations performed during intervals P11, P12, P15, and P16 in FIG. 5, respectively.

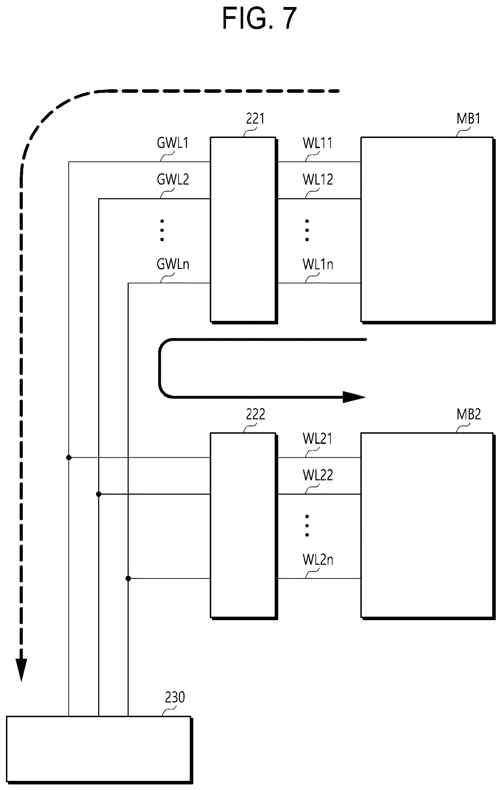

FIG. 7 is diagram illustrating a charge recycling operation according to an embodiment of the present disclosure.

Referring to FIG. 7, the dashed arrow represents that, during interval P3 of FIG. 4, charges retained in the unselected first word lines UNSELWL1 of the first memory block MB1 after the first read operation is performed on the first memory block MB1 are discharged through the discharge circuit 230.

The solid arrow represents that, during interval P13 of FIG. 5 or interval P23 of FIG. 6, charges retained in the unselected first word lines UNSELWL1 of the first memory block MB1 after the first read operation is performed on the first memory block MB1 move to target word lines TG of the second memory block MB2 during the charge recycling operation. Using such a charge recycling operation, power consumption of the memory device 100 during the read operation may be significantly reduced.

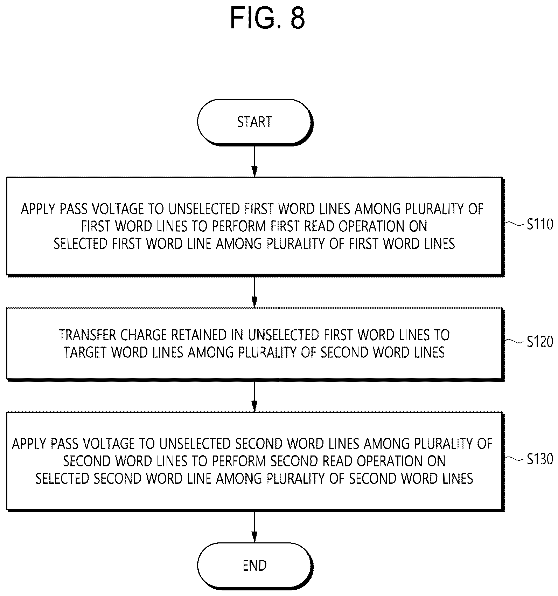

FIG. 8 is a flowchart illustrating a method of operating a memory device according to an embodiment of the present disclosure. The processes of the flowchart may be performed in a different order and may include fewer or additional processes than described and shown in FIG. 8.

Referring to FIG. 8, the peripheral circuit 120 applies S110 a pass voltage to unselected first word lines among a plurality of first word lines coupled to a first memory block to perform a first read operation on a selected first word line among the plurality of first word lines. The pass voltage is applied S110 to global word lines coupled to the unselected first word lines among a plurality of global word lines while activating first switches coupled between the plurality of first word lines and the plurality of global word lines.

The peripheral circuit 120 transfers S120 charge retained in the unselected first word lines to target word lines among a plurality of second word lines coupled to a second memory block, including activating second switches coupled between the plurality of second word lines and the plurality of global word lines while the first switches coupled between the plurality of first word lines and the plurality of global word lines remain activated.

The peripheral circuit 120 applies S130 the pass voltage to unselected second word lines among the plurality of second word lines to perform a second read operation on a selected second word line among the plurality of second word lines, including applying the pass voltage to global word lines coupled to the unselected second word lines among the plurality of global word lines while activating second switches coupled between the plurality of second word lines and the plurality of global word lines

Concepts are disclosed in conjunction with examples and embodiments. Those skilled in the art will understand that various modifications, additions, combinations, and substitutions are possible without departing from the scope and technical concepts of the present disclosure. The embodiments disclosed in the present specification should be considered from an illustrative standpoint and not a restrictive standpoint. Therefore, the scope of the present disclosure is not limited to the provided descriptions. All changes within the meaning and range of equivalency of the claims are included within their scope.

## Claims

1. A memory device comprising:
a first memory block coupled to a plurality of first word lines and a second memory block coupled to a plurality of second word lines;
a decoder configured to couple a plurality of global word lines to the plurality of first word lines, respectively, in response to a first memory block selection signal and configured to couple the plurality of global word lines to the plurality of second word lines, respectively, in response to a second memory block selection signal; and
a control circuit configured to activate the first memory block selection signal to perform a first read operation on a selected first word line among the plurality of first word lines during a first interval, configured to activate the first memory block selection signal and the second memory block selection signal during a second interval subsequent to the first interval, and configured to activate the second memory block selection signal to perform a second read operation on a selected second word line among the plurality of second word lines during a third interval subsequent to the second interval.

2. The memory device of claim 1, further comprising a voltage generation circuit configured to output a pass voltage to a pass voltage node;
wherein the decoder is configured to couple global word lines, among the plurality of global word lines, coupled to unselected first word lines to the pass voltage node, respectively, during the first interval, and configured to couple global word lines, among the plurality of global word lines, coupled to unselected second word lines to the pass voltage node, respectively, during the third interval.

3. The memory device of claim 1, further comprising a voltage generation circuit configured to output a read voltage to a read voltage node;
wherein the decoder is configured to couple a first global word line, among the plurality of global word lines, coupled to the selected first word line to the read voltage node during the first interval, and configured to couple a second global word line, among the plurality of global word lines, coupled to the selected second word line to the read voltage node during the third interval.

4. The memory device of claim 1, wherein the control circuit is configured to deactivate the second memory block selection signal during the first interval and configured to deactivate the first memory block selection signal during the third interval.

5. The memory device of claim 1, wherein the control circuit is configured to output data read by the first read operation to a controller during the second interval.

6. The memory device of claim 1, wherein the control circuit is configured to discharge the plurality of second word lines during a fourth interval subsequent to the third interval when a read operation does not follow the second read operation during a predetermined time period.

7. The memory device of claim 1, wherein the control circuit is configured to discharge the selected first word line before entering the second interval after a predetermined time period has elapsed since entering the first interval.

8. A method of operating a memory device, the method comprising:
applying a pass voltage to unselected first word lines among a plurality of first word lines coupled to a first memory block to perform a first read operation on a selected first word line among the plurality of first word lines;
transferring charge retained at the unselected first word lines to target word lines among a plurality of second word lines coupled to a second memory block before performing a second read operation on a selected second word line among the plurality of second word lines; and
applying the pass voltage to unselected second word lines among the plurality of second word lines to perform the second read operation.

9. The method of claim 8, wherein transferring charge retained at the unselected first word lines to the target word lines comprises activating second switches coupled between the plurality of second word lines and a plurality of global word lines while first switches coupled between the plurality of first word lines and the plurality of global word lines are activated.

10. The method of claim 9, wherein applying the pass voltage to the unselected first word lines comprises applying the pass voltage to global word lines, among the plurality of global word lines, coupled to the unselected first word lines while the first switches are activated.

11. The method of claim 9, wherein applying the pass voltage to the unselected second word lines comprises applying the pass voltage to global word lines, among the plurality of global word lines, coupled to the unselected second word lines while the second switches are activated.

12. A method of operating a memory device, the method comprising:
raising voltage levels of target word lines to a first voltage level using charge retained in source word lines; and
raising voltage levels of unselected word lines of a read operation among the target word lines from the first voltage level to a second voltage level using a voltage output from a voltage generation circuit.

13. The method of claim 12, wherein when the target word lines include a selected word line used when the read operation is performed, the method further comprising lowering a voltage level of the selected word line to a read voltage while raising the voltage levels of the unselected word lines from the first voltage level to the second voltage level.

14. The method of claim 12, further comprising applying the voltage generated from the voltage generation circuit to the source word lines before raising the voltage levels of the target word lines to the first voltage level.

15. The method of claim 12, wherein the source word lines are coupled to a first memory block, and the target word lines are coupled to a second memory block.
